# EUROPÄISCHE PATENTSCHRIFT

(11) **EP 2 464 986 B1**
(45) Veröffentlichungstag und Bekanntmachung des Hinweises auf die Patenterteilung: **26.02.2014**
(21) Anmeldenummer: 10721919.8
(22) Anmeldetag: 02.06.2010
(51) Int. Cl.: G01R 31/08, H02H 3/087

(54) **VERFAHREN ZUR LICHTBOGENDETEKTION IN PHOTOVOLTAIKANLAGEN UND EINE SOLCHE PHOTOVOLTAIKANLAGE**
METHOD FOR DETECTING ARCS IN PHOTOVOLTAIC SYSTEMS AND SUCH A PHOTOVOLTAIC SYSTEM
PROCÉDÉ DE DÉTECTION D'ARCS ÉLECTRIQUES DANS DES INSTALLATIONS PHOTOVOLTAÏQUES ET UNE TELLE INSTALLATION PHOTOVOLTAÏQUE

(30) Priorität: 14.08.2009 AT 12852009
(43) Veröffentlichungstag der Anmeldung: 20.06.2012
(73) Patentinhaber: Fronius International GmbH, 4643 Pettenbach (AT)
(72) Erfinder: PAMER, Andreas, A-4702 Wallern (AT); RITZBERGER, Günter, A-4052 Ansfelden (AT); OBERZAUCHER, Friedrich, A-4600 Wels (AT)
(74) Vertreter: Sonn & Partner Patentanwälte
(86) Internationale Anmeldenummer: PCT/AT2010/000194
(87) Internationale Veröffentlichungsnummer: WO 2011/017721

(56) Entgegenhaltungen:
- EP-A1- 1 918 727
- WO-A1-95/25374
- DE-A1- 19 633 527
- DE-A1-102004 056 436
- FR-A1- 2 912 848
- US-A1- 2004 150 410
- H. HAEBERLIN, MARKUS REAL: "Arc Detector for Remote Detection of Dangerous Arcs on the DC Side of PV Plants" CONFERENCE PROCEEDINGS OF 22ND EUROPEAN PHOTOVOLTAIC SOLAR ENERGY CONFERENCE, MILANO, ITALY, September 2007 (2007-09), Seiten 1-6, XP002600942 22nd European Photovoltaic Solar Energy Conference, Milano, Italy

## Beschreibung

Die Erfindung betrifft ein Verfahren zur Detektion von Lichtbögen in einem Gleichstrompfad einer Photovoltaikanlage nach dem Oberbegriff des Anspruchs 1.

Ebenso betrifft die Erfindung eine Photovoltaikanlage nach dem Oberbegriff des Anspruchs 14.

Gleichstromlichtbögen, wie Serienlichtbögen oder Parallellichtbögen, führen in Photovoltaikanlagen oft zu gefährlichen und teuren Bränden, weil sich das umliegende Material in kürzester Zeit entzündet. Da Gleichstromlichtbögen keinen Nulldurchgang besitzen, erlöschen diese nicht selbstständig. Daher ist eine Detektion von Lichtbögen erforderlich.

Aus der WO 95/25374 A1 ist ein Detektionsverfahren für Serien- und Parallellichtbögen bekannt. Hierbei wird die Detektionseinheit mit den Gleichstromhauptleitungen der Photovoltaikanlage verbunden, damit Spannungsänderungen und somit Lichtbögen detektiert werden können. Die Detektionseinheit ist dabei analog aufgebaut und umfasst insbesondere zwei induktiv gekoppelte Schwingkreise, zwei Komparatoren und eine Verzögerungsstufe, sodass ein DC-Trenner in der Gleichstromhauptleitung aktiviert und deaktiviert werden kann. Nachteilig ist hierbei, dass zusätzliche Hardwarekomponenten für das Detektionsverfahren in die Photovoltaikanlage integriert werden müssen, wodurch zusätzliche Kosten entstehen. Ebenso ist von Nachteil, dass im Wesentlichen keine nachträglichen Änderungen bzw. Anpassungen von Parametern des Detektionsverfahrens möglich sind.

Ein weiteres Detektionsverfahren für Serien- und Parallellichtbögen ist aus der EP 1 796 238 A2 bekannt, welches mit einem Softwaremodul durchgeführt wird. Zur Detektion eines Serienlichtbogens wird in Zeitfenstern des Stromverlaufs der arithmetische Mittelwert gebildet. Überschreitet die Differenz der Mittelwerte während zweier aufeinanderfolgender Zeitfenster einen Schwellwert, wird ein Zähler erhöht. Bleibt die Differenz unter dem Schwellwert, wird der Zähler verringert. Ein Serienlichtbogen wird dann detektiert, wenn der Zählerstand einen gewissen Wert überschreitet. Zur Detektion eines Parallellichtbogens wird in einem Zeitfenster ein Maximum und ein Minimum des Stromverlaufs bestimmt und die Differenz davon berechnet. Ist die Differenz größer als ein bestimmter Schwellwert, wird ein weiterer Zähler erhöht. Bleibt die Differenz unter dem Schwellwert, wird dieser Zähler verringert. Ein Parallellichtbogen wird dann detektiert, wenn der Zählerstand einen gewissen Wert überschreitet. Nachteilig ist hierbei, dass lediglich der Stromverlauf berücksichtigt wird. Ebenso wird erst nach mehreren Stromänderungen ein Lichtbogen detektiert, sodass bereits ein Schaden entstehen kann. Auch ist nachteilig, dass unterschiedliche Detektionsverfahren für Serienlichtbögen und Parallellichtbögen eingesetzt werden.

Die DE 10 2004 056 436 A1 beschreibt ein Verfahren und eine Vorrichtung zur Erkennung von Fehlerstromlichtbögen in elektrischen Stromkreisen, wobei Werte eines Stroms eines Gleichstrompfads während eines sich wiederholenden Zeitfensters erfasst werden und ein Mittelwert gebildet wird, sowie während der Zeitfenster Werte einer Spannung des Gleichstrompfads erfasst werden und ein Mittelwert gebildet wird, und basierend auf den Mittelwerten für den Strom und die Spannung über die Spannung über ein Berechnungsverfahren zumindest ein Detektionssignal und zumindest eine Detektionsschwelle kontinuierlich berechnet wird, ohne dass eine Anwendung in einem Gleichstrompfad einer Photovoltaikanlage erwähnt wird.

Die Aufgabe der Erfindung besteht darin, ein oben genanntes Verfahren und eine oben genannte Photovoltaikanlage zu schaffen, mit der die Sicherheit der Photovoltaikanlagen mit einer Komponente der Photovoltaikanlage überwacht werden kann. Nachteile bekannter Systeme sollen vermieden oder zumindest reduziert werden.

Die Aufgabe der Erfindung wird in verfahrensmäßiger Hinsicht dadurch gelöst, dass während der Zeitfenster Werte einer Spannung des Gleichstrompfads erfasst und ein Mittelwert der Spannung gebildet wird, aus den jeweiligen Mittelwerten des Stroms und der Spannung Differenzmittelwerte und Langzeitmittelwerte des Stroms und der Spannung berechnet werden, aus den aktuellen Differenzmittelwerten des Stroms und der Spannung Langzeitdifferenzmittelwerte des Storms und der Spannung berechnet werden, und dass basierend auf den Mittelwerten, Differenzmittelwerten, Langzeitmittelwerten und Langzeitdifferenzmittelwerten für den Strom und die Spannung über ein Berechnungsverfahren zumindest ein Detektionssignal und zumindest eine Detektionsschwelle kontinuierlich berechnet wird, indem aus dem Langzeitdifferenzmittelwert und dem Differenzmittelwert der Spannung ein Wert gebildet wird und mit einem aus dem Langzeitdifferenzmittelwert und dem Differenzmittelwert des Stroms gebildeten Wert zur Bildung des Detektionssignals multipliziert wird.

Ebenso wird die Aufgabe der Erfindung durch eine oben genannte Photovoltaikanlage gelöst, bei der eine Messeinrichtung zur Messung der Gleichspannung und des Gleichstromes vorgesehen ist, und dass die Steuereinrichtung zur Durchführungdes oben genannten Detektionsverfahrens ausgebildet ist.

Vorteilhaft ist hierzu und zu den weiteren Ansprüchen, dass die Detektion immer im Verhältnis zur Ausgangsleistung des Wechselrichters durchgeführt wird, da Strom und Spannung erfasst werden. Dadurch kann das Detektionsverfahren zwischen Lichtbögen und Einstrahlungsänderungen unterscheiden. Somit werden auch Lichtbögen mit kleineren Leistungen erkannt, wodurch eine Früherkennung der Lichtbögen erfolgt. Von Vorteil ist auch, dass die Empfindlichkeit des Verfahrens über Korrekturfaktoren einstellbar ist und mit einer Komponente der Photovoltaikanlage, beispielsweise mit der Steuereinrichtung des Wechselrichters, durchführbar ist. Somit kann das in vorteilhafter Weise digital ausgebildete Verfahren durch ein Softwareupdate implementiert werden. Daher wird auch eine einfache Umrüstung bzw. Integration in zumindest eine bestehende Komponente der Photovoltaikanlage erreicht. Vorteilhaft ist des Weiteren, dass das Detektionsverfahren auch mit einer geringen Abtastrate (bis in den Hundert-H-z-Bereich) durchgeführt werden kann. Dadurch müssen entsprechend weniger Werte verarbeitet werden, sodass vorhandene Ressourcen verwendet bzw. die Bauteilkosten gering gehalten werden können.

Weitere Vorteile können der nachfolgenden Beschreibung entnommen werden.

Die vorliegende Erfindung wird anhand der beigefügten, schematischen Zeichnungen näher erläutert, wobei die in der gesamten Beschreibung enthaltenen Offenbarungen sinngemäß auf gleiche Teile mit gleichen Bezugszeichen übertragen werden können. Weiters können auch Einzelmerkmale aus dem gezeigten Ausführungsbeispiel bzw. aus den gezeigten Ausführungsbeispielen für sich eigenständige, erfindungsgemäße Lösungen darstellen.

Darin zeigen:
Fig. 1 ein schematisches Blockschaltbild einer Photovoltaikanlage;
Fig. 2 schematische zeitliche Verläufe von Strom und Spannung einer Photovoltaikanlage zur Ermittlung der jeweiligen Mittelwerte;
Fig. 3 einen schematischen zeitlichen Verlauf des Mittelwerts und des Langzeitmittelwerts der Spannung bis zum Auftreten eines Lichtbogens sowie das resultierende Detektionssignal;
Fig. 4 einen schematischen zeitlichen Verlauf des Mittelwerts und des Langzeitmittelwerts des Stroms bis zum Auftreten eines Lichtbogens sowie das resultierende Detektionssignal;
Fig. 5 schematisch einen Zeitverlauf während der Detektion eines Serienlichtbogens;
Fig. 6 schematisch einen Zeitverlauf während der Detektion eines Parallellichtbogens; und
Fig. 7 schematisch die bei einem Lichtbogen resultierenden Arbeitspunkte des Wechselrichters einer Photovoltaikanlage.

Einführend wird festgehalten, dass gleiche Teile des Ausführungsbeispiels mit gleichen Bezugszeichen versehen werden.

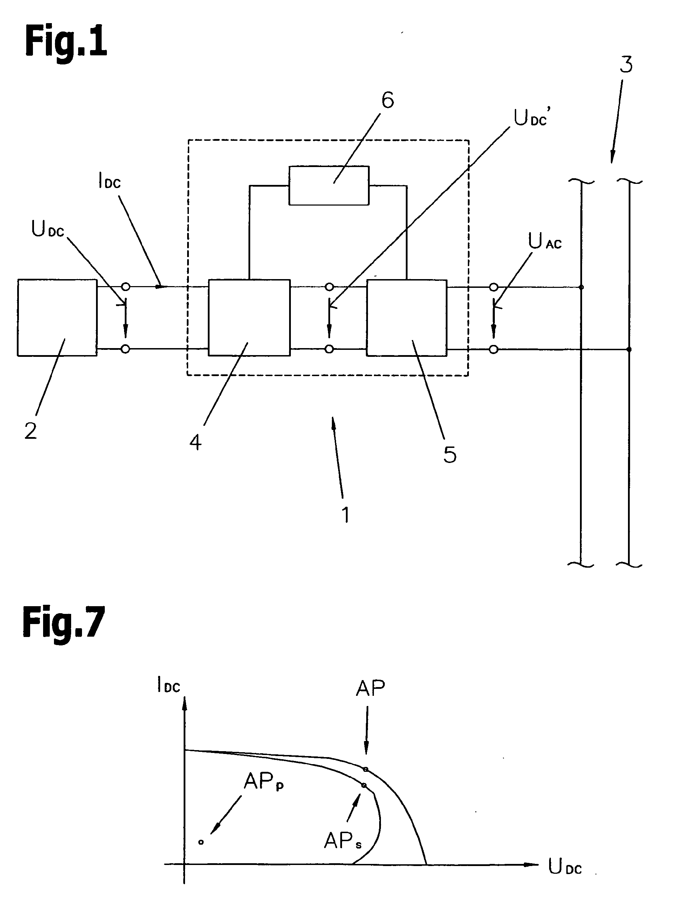

Anhand der Fig. 1 bis 7 wird ein Verfahren zur Detektion von Lichtbögen in einem Gleichstrompfad einer Photovoltaikanlage beschrieben.

Dabei zeigt Fig. 1 ein Blockschaltbild eines Wechselrichters 1 einer Photovoltaikanlage zum Einspeisen einer von zumindest einer Solarzelle 2 erzeugten Eingangsgleichspannung U_{DC} mit zugehörigem Eingangsgleichstrom I_{DC} in eine Wechselspannung U_{AC}, welche in ein Wechselspannungsnetz 3 eingespeist wird oder einem Verbraucher zur Verfügung gestellt wird. Die Photovoltaikanlage kann neben dem Wechselrichter 1 weitere Komponenten, wie zum Beispiel eine Anschlussbox und/oder Ähnliches (nicht dargestellt) aufweisen. Der Wechselrichter 1 beinhaltet einen DC-D-C-Wandler 4, welcher die Eingangsgleichspannung U_{DC} in eine für den nachfolgenden DC-AC-Wandler 5 des Wechselrichters 1 geeignete Gleichspannung U_{DC}' umwandelt. Durch den DC-AC-Wandler 5 und eine entsprechende Steuereinrichtung 6 wird die Gleichspannung U_{DC}' in die Wechselspannung U_{AC} umgewandelt. Entsprechend befindet sich zwischen der Solarzelle 2 und dem Wechselrichter 1 (strichliert dargestellt) der Gleichstrompfad. Dieser fasst im Wesentlichen alle parallel und in Serie geschalteten Solarzellen 2 beispielsweise in einer Anschlussbox zusammen, welche mit dem Wechselrichter 1 verbunden ist. Demzufolge umfasst der Gleichstrompfad mehrere Leitungen und Kontaktstellen, wobei der Übersicht halber nur eine Leitung dargestellt ist.

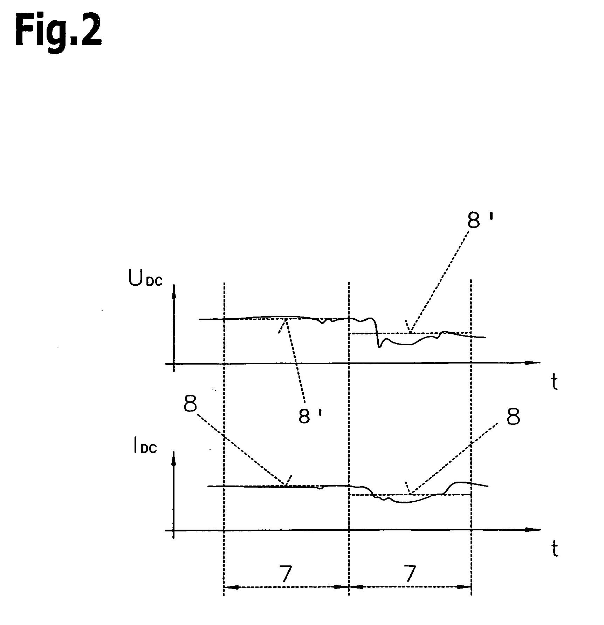

Die Kontaktstellen können dabei beispielsweise durch Temperaturschwankungen, Alterung, Installationsmängel und/oder schlechter Verschraubung/Klemmung gelockert werden, und dadurch sogenannte Serienlichtbögen entstehen. Im Gegensatz dazu resultieren Parallellichtbögen hauptsächlich aufgrund von Mängeln bzw. Beschädigungen der Isolation, wenn die Leitungen nebeneinander geführt sind. Die Lichtbögen entstehen während des Betriebs des Wechselrichters 1 aufgrund des im Gleichstrompfad fließenden Stroms I_{DC} und können zu gefährlichen Bränden führen. Um dies zu verhindern, werden Verfahren zur Detektion solcher Lichtbögen eingesetzt. Dabei werden Werte des Stroms I_{DC} des Gleichstrompfads während eines sich wiederholenden Zeitfensters 7 erfasst und daraus pro Zeitfenster 7 ein Mittelwert 8, 8' gebildet, wie dies in Fig. 2 ersichtlich ist. Der aktuelle Mittelwert 8, 8' bzw. der Mittelwert 8, 8' des letzten Zeitfensters 7 wird dann mit dem Mittelwert 8, 8' des vorhergehenden Zeitfensters 7 verglichen. Erfindungsgemäß ist nun vorgesehen, dass während der Zeitfenster 7 Werte der Spannung U_{DC} und des Stroms I_{DC} des Gleichstrompfads erfasst und jeweils ein Mittelwert 8, 8' gebildet wird, und basierend auf den Mittelwerten 8, 8' für Strom I_{DC} und Spannung U_{DC} über ein Berechnungsverfahren ein Detektionssignal 9 und eine Detektionsschwelle 10 kontinuierlich berechnet wird. Durch Vergleichen des Detektionssignals 9 mit der Detektionsschwelle 10 wird ein Serien- und/oder Parallellichtbogen erkannt.

Als Grundlage für das Detektionsverfahren dienen die kontinuierlich am Eingang der Komponente der Photovoltaikanlage - wie dem Wechselrichter 1 - mit einer Messeinrichtung erfassten Werte für die Spannung U_{DC} und den Strom I_{DC} des Gleichstrompfads. Diese gemessenen Werte werden dem Berechnungsverfahren zur Verfügung gestellt, welches beispielsweise mit der Steuereinrichtung 6 des Wechselrichters 1 durchgeführt wird. Grundsätzlich kann die Berechnung für die Spannung U_{DC} und den Strom I_{DC} in gleicher Weise durchgeführt werden. Wesentlich für das Detektionsverfahren ist auch, dass eine Änderung der Lichteinstrahlung nicht als Lichtbogen detektiert wird. Ein Lichtbogen verursacht eine einmalige, schnelle Änderung des Stroms I_{DC} und der Spannung U_{DC}, wohingegen Änderungen der Einstrahlung im Vergleich dazu langsam und kontinuierlich erfolgen.

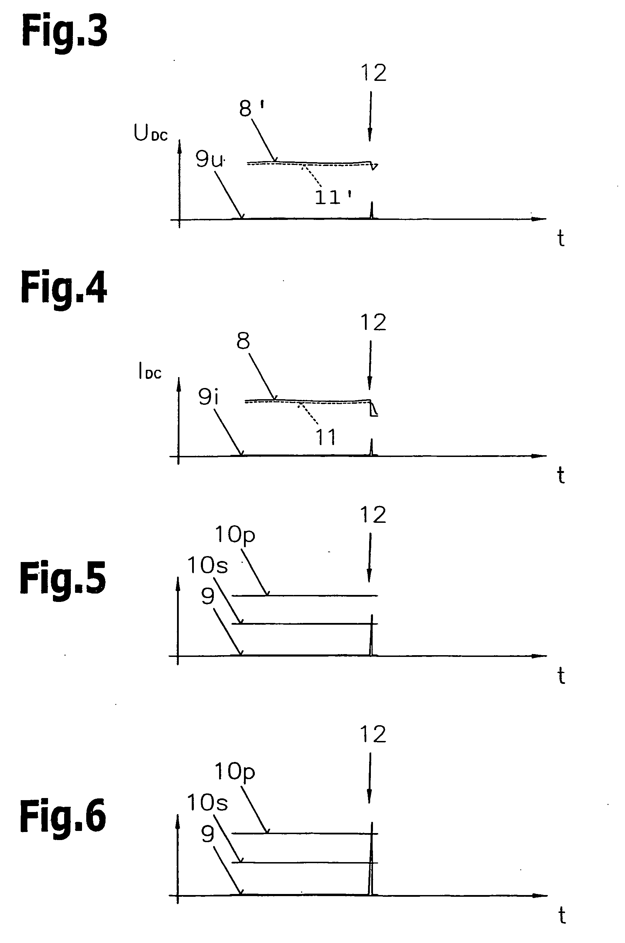

Das Detektionsverfahren wird nach einem Startvorgang des Wechselrichters 1 gestartet, wobei die Werte des Detektionsverfahrens mit dem Startvorgang vorzugsweise rückgesetzt werden. Die Messeinrichtung liefert die kontinuierlich gemessenen Werte, welche vom Berechnungsverfahren in gleich große Zeitfenster 7 unterteilt werden. In jedem Zeitfenster 7 werden die Werte für den Strom I_{DC} und die Spannung U_{DC} mit einer Abtastfrequenz erfasst, wobei die Zeitfenster 7 eine definierte Dauer von beispielsweise 50 ms aufweisen. Nach einem Zeitfenster 7 werden aus den im Zeitfenster 7 erfassten Werten der aktuelle Mittelwert 8 des Stroms I_{DC} und der aktuelle Mittelwert 8' der Spannung U_{DC} gebildet, wie in den Diagrammen in Fig. 2 dargestellt ist. Durch die Berechnung der Mittelwerte 8, 8' werden sporadische Änderungen entsprechend ausgeglichen. Die Mittelwerte 8, 8' des Stromes I_{DC} und der Spannung U_{DC} sind innerhalb der Zeitfenster 7 strichliert eingezeichnet. Der zeitliche Verlauf dieser einzelnen Mittelwerte 8, 8' ist anhand eines Beispiels in den Fig. 3 und 4 dargestellt.

Im nächsten Schritt wird mit dem Berechnungsverfahren jeweils aus den aktuellen Mittelwerten 8, 8' und den Mittelwerten 8, 8' des vorhergehenden Zeitfensters 7, also aus zwei aufeinander folgenden Mittelwerten 8, 8', ein Differenzmittelwert berechnet. Somit können schnelle Änderungen zwischen zwei Zeitfenstern 7 erkannt werden.

Auch werden die aktuellen Mittelwerte 8, 8' zur Berechnung der jeweiligen aktuellen Langzeitmittelwerte 11 herangezogen, welche kontinuierlich aktualisiert werden. Der Verlauf der Langzeitmittelwerte 11, 11' ist ebenfalls in den Fig. 3 und 4 dargestellt.

Die Langzeitmittelwerte 11, 11' werden aus den aktuellen Mittelwerten 8, 8' mittels einer digitalen Tiefpassfilterung berechnet, sodass der Einfluss des aktuellen Mittelwerts 8, 8' auf den aktuellen Langzeitmittelwert 11, 11' gering ist. Mit geeignet gewählten Zeitkonstanten bzw. Filterkoeffizienten kann damit gewährleistet werden, dass Lichtbögen von Einstrahlungsänderungen unterschieden werden können. Der aktuelle Langzeitmittelwert 11, 11' ändert sich demnach im Vergleich zur schnellen Änderung des Mittelwerts 8, 8' im Wesentlichen nur langsam.

Nach demselben Prinzip werden auch die jeweiligen Langzeitdifferenzmittelwerte durch digitale Tiefpassfilterung mit den gleichen Filterkoeffizienten aus den jeweiligen aktuellen Differenzmittelwerten berechnet. Entsprechend ist auch hier der Einfluss des jeweiligen Differenzmittelwerts gering. Somit verhält sich der Langzeitdifferenzmittelwert wie ein Verzögerungsglied, sodass sich dieser langsamer als der Differenzmittelwert ändert. Demzufolge dienen die Langzeitdifferenzmittelwerte als Maß für die Einstrahlungsstärke, wodurch Lichtbögen von Einstrahlungsänderungen unterschieden werden können.

Anhand der Differenzmittelwerte, der Langzeitmittelwerte 11, 11' und der Langzeitdifferenzmittelwerte - welche entsprechend auf Basis der Mittelwerte 8, 8' berechnet wurden - kann nun sowohl das Detektionssignal 9 als auch die Detektionsschwelle 10 berechnet werden.

Zur Berechnung des Detektionssignals 9 wird ein Wert aus dem Langzeitdifferenzmittelwert und dem Differenzmittelwert der Spannung U_{DC} gebildet - welcher einem Detektionssignal 9u für die Spannung U_{DC} entspricht - und mit einem aus dem Langzeitdifferenzmittelwert und dem Differenzmittelwert des Stroms I_{DC} gebildeten Wert - welcher einem Detektionssignal 9i für den Strom I_{DC} entspricht - multipliziert. Dabei sind die Werte jeweils die Differenz zwischen dem Langzeitdifferenzmittelwert und dem Differenzmittelwert, welche zum gleichen Zeitpunkt berechnet wurden. Demnach resultiert eine größere Differenz bei schnellen Änderungen der Spannung U_{DC} bzw. des Stroms I_{DC}. Dies deshalb, da sich schnelle Änderungen im Differenzmittelwert viel deutlicher auswirken als im Langzeitdifferenzmittelwert. Auch ist dadurch sichergestellt, dass es sich um kurze, schnelle Änderungen handelt, wie dies beim Zünden eines Lichtbogens der Fall ist. Handelt es sich um Änderungen aufgrund der Einstrahlungsstärke, hat dies gleiche Auswirkungen auf den Langzeitmittelwert 11, 11' und den Mittelwert 8, 8', da solche Änderungen über einen längeren Zeitraum erfolgen, sodass die Differenz im Wesentlichen Null ist.
Gemäß den Fig. 3 und 4 ist eine schnelle Änderung zum Zeitpunkt 12 anhand der Mittelwerte 8, 8' und Langzeitmittelwerte 11, 11' dargestellt, aus welchen die entsprechenden Detektionssignale 9u bzw. 9i resultieren. Entsprechend resultiert bei langsamen Änderungen kein Detektionssignal 9u bzw. 9i.

Durch Multiplikation dieser beiden Differenzen bzw. der Detektionssignale 9u und 9i von Strom I_{DC} und Spannung U_{DC} wird die Änderung entsprechend verstärkt, sodass ein Lichtbogen schnell erkannt wird. Aus einer derartigen Berechnung resultiert, dass das Detektionssignal 9 im Wesentlichen Null ist, solange keine schnellen Änderungen der Spannung U_{DC} und des Stroms I_{DC} zeitgleich auftreten. Das heißt also, dass sich bei langsamen Änderungen der Langzeitdifferenzmittelwert und der Differenzmittelwert gleich verhalten, sodass deren Differenz und entsprechend das Detektionssignal 9 Null ist. Resultiert allerdings durch einen auftretenden Lichtbogen eine schnelle, zeitgleiche Änderung, ändert sich auch das Detektionssignal 9 deutlich. Somit spiegelt das Detektionssignal 9 im Wesentlichen die Leistungsänderung wieder, welche den Leistungsverlust aufgrund des Lichtbogens beschreibt.

Zur Berechnung der Detektionsschwelle 10 werden hingegen die zum gleichen Zeitpunkt berechneten Langzeitmittelwerte 11 von Strom I_{DC} und Spannung U_{DC} multipliziert. Somit entspricht die Detektionsschwelle 10 im Wesentlichen der aktuellen Leistung.

Durch eine derartige Berechnung des Detektionssignals 9 und der Detektionsschwelle 10 sind diese immer an die Ausgangsleistung des Wechselrichters 1 angepasst, da diese kontinuierlich basierend auf der Spannung U_{DC} und des Stroms I_{DC} berechnet werden.

Damit in weiterer Folge ein Lichtbogen detektiert werden kann, muss das Detektionssignal 9 die Detektionsschwelle 10 überschreiten, wie zum Zeitpunkt 12 gemäß Fig. 5 und 6 ersichtlich. Um einen Lichtbogen zu detektieren müsste die Leistungsänderung die aktuelle Leistung überschreiten. Da dies nicht möglich ist, wird zumindest zur Berechnung der Detektionsschwelle 10 oder des Detektionssignals 9 ein Korrekturfaktor eingesetzt. Selbstverständlich kann sowohl zur Berechnung der Detektionsschwelle 10 als auch zur Berechnung des Detektionssignals 9 jeweils ein Korrekturfaktor multiplikativ eingesetzt werden. Dabei weist der Korrekturfaktor für das Detektionssignal 9 einen Wert größer Eins und der Korrekturfaktor für die Detektionsschwelle 10 einen Wert kleiner Eins auf. Somit ist gewährleistet, dass auch Lichtbögen mit geringer Leistung - also mit kurzer Lichtbogenlänge - erkannt werden können. Aufgrund dieser Berechnungen wird die Detektionsschwelle 10 an langsame Änderungen des Stroms I_{DC} und der Spannung U_{DC} angepasst. Da die Detektionsschwelle 10 der aktuellen Leistung entspricht und die Leistung wiederum von der Einstrahlungsstärke abhängt, ist die Detektionsschwelle 10 automatisch an die aktuellen Gegebenheiten angepasst. Zusätzlich kann durch die jeweiligen Korrekturfaktoren die Empfindlichkeit der Detektion der Lichtbögen angepasst werden, indem der Korrekturfaktor für die Detektionsschwelle 10 und der Korrekturfaktor für das Detektionssignal 9 aufeinander entsprechend abgestimmt werden.

Grundsätzlich wird für einen Serienlichtbogen und einen Parallellichtbogen ein unterschiedlicher Korrekturfaktor zur Berechnung der jeweiligen Detektionsschwelle 10 verwendet, sodass eine Detektionsschwelle 10s für einen Serienlichtbogen und eine Detektionsschwelle 10p für einen Parallellichtbogen resultiert. Zur Detektion eines Lichtbogens wird dabei das gemeinsame Detektionssignal 9 verwendet. Somit kann zum Einen ein gemeinsames Detektionsverfahren für beide Arten von Lichtbögen verwendet werden und zum Anderen auch eine Erkennung der Art des auftretenden Lichtbogens ermöglicht werden. Zurückzuführen ist dies auf ein unterschiedliches Verhalten der Photovoltaikanlage bei einem Serienlichtbogen und bei einem Parallellichtbogen, wodurch der Wechselrichter 1 den Arbeitspunkt AP ändert, wie in Fig. 7 dargestellt.

Tritt in der Photovoltaikanlage ein Serienlichtbogen auf, verringert sich die Eingangsgleichspannung U_{DC} durch den Lichtbogenspannungsabfall, wodurch der Wechselrichter 1 seinen Arbeitspunkt AP auf einen Arbeitspunkt APₛ aufgrund des Serienlichtbogens verändert. Dadurch sinkt zwar die Ausgangsleistung, aber der Betrieb des Wechselrichters 1 ist weiterhin möglich. Im Gegensatz zu einer geringfügigen Änderung des Arbeitspunktes AP bei einem Serienlichtbogen ändert sich der Arbeitspunkt AP im Falle eines Parallellichtbogens erheblich. Da der Parallellichtbogen parallel zum Eingang des Wechselrichters 1 mit einer gewissen geringen Lichtbogenspannung brennt und einen gegenüber dem Wechselrichterwiderstand niederohmigen Lichtbogenwiderstand aufweist, fließt nur ein sehr geringer Teil des Stroms I_{DC} zum Wechselrichter 1. Demzufolge verändert sich der Arbeitspunkt AP gemäß Fig. 7 deutlich, sodass ein Arbeitspunkt APₚ aufgrund des Parallellichtbogens resultiert. Mit einem derartigen Arbeitspunkt APₚ ist ein sinnvoller Betrieb des Wechselrichters 1 nicht mehr möglich.

Die Spannungsänderung und Stromänderung ist also bei einem Parallellichtbogen viel größer als bei einem Serienlichtbogen. Demzufolge ist die Detektionsschwelle 10p für einen Parallellichtbogen auch höher als die Detektionsschwelle 10s für einen Serienlichtbogen. Überschreitet das Detektionssignal 9 die Detektionsschwelle 10s für den Serienlichtbogen und nicht für die Detektionsschwelle 10p für den Parallellichtbogen gemäß Fig. 5, wird ein Serienlichtbogen detektiert. Werden vom Detektionssignal 9 beide Detektionsschwellen 10s und 10p gemäß Fig. 6 überschritten, wird hingegen ein Parallellichtbogen detektiert. Das Detektionssignal 9 wird gemäß dem Berechnungsverfahren bei schnellen Änderungen von Strom und/oder Spannung bzw. des Arbeitspunktes AP gebildet, wobei bei langsamen Änderungen des Arbeitspunktes AP aufgrund von Änderungen der Einstrahlungsstärke im Wesentlichen kein Detektionssignal 9 gebildet wird.

Nachdem mit dem Berechnungsverfahren das Detektionssignal 9 und die Detektionsschwellen 10s und 10p berechnet wurden, werden gemäß dem Detektionsverfahren das Detektionssignal 9 und die Detektionsschwellen 10s/10p miteinander verglichen. Überschreitet dabei das Detektionssignal 9 zumindest eine der Detektionsschwellen 10s/10p, ist ein Lichtbogen aufgetreten. Das heißt, dass entweder ein Serienlichtbogen oder ein Parallellichtbogen detektiert wurde. Eine Unterscheidung der Lichtbogenart ist erforderlich, da nach einer Detektion auch unterschiedliche Maßnahmen erforderlich sind.

Wird das Detektionsverfahren in einer anderen Komponente der Photovoltaikanlage als dem Wechselrichter 1 (wie beschrieben) durchgeführt, erfolgt eine entsprechende Kommunikation dieser anderen Komponente mit dem Wechselrichter 1. Die Kommunikation kann beispielsweise drahtlos oder drahtgebunden erfolgen (eigenes Bussystem, aufmoduliert auf den Gleichstrompfad, usw.).

Bei Detektion eines Serienlichtbogens wird der Wechselrichter derart in einen sicheren Zustand gebracht, indem im Wesentlichen kein Wechselstrom mehr erzeugt wird. Demnach wird der Stromfluss im Gleichstrompfad unterbrochen und der Lichtbogen erlischt. Wird hingegen ein Parallellichtbogen detektiert, wird der Gleichstrompfad durch einen Schalter kurzgeschlossen. Dadurch wird die Lichtbogenspannung im Wesentlichen Null, sodass der Lichtbogen erlischt. Als Schalter kann dabei der DC-DC-Wandler 4 verwendet werden oder aber auch ein eigener, zum Wechselrichter 1 parallel geschalteter Schalter.

Das beschriebene Detektionsverfahren kann auch mit einer frequenzselektiven Auswertung (z.B. durch digitale Filter) und/oder mit einer Auswertung im Frequenzbereich (z.B. Fast Fourier Transformation) kombiniert werden. Dabei wird aufgrund der Höhe der Spektralanteile im Verlauf der Spannung U_{DC} und/oder des Stroms I_{DC} ein zusätzliches Detektionssignal 9 und eine zusätzliche Detektionsschwelle 10 erzeugt, welche mit den Ergebnissen des Berechnungsverfahrens entsprechend kombiniert werden können. Somit wird die Zuverlässigkeit weiter erhöht.

Auch kann eine Alarmmeldung generiert werden, welche über das Internet, Mobilfunk oder dergleichen versendet wird.

Wird kein Lichtbogen detektiert, bleibt also das Detektionssignal 9 unter der Detektionsschwelle 10, läuft das Detektionsverfahren weiter. Im Allgemeinen wird das Detektionsverfahren während des Betriebs des Wechselrichters 1 durchgeführt. Gestartet wird das Detektionsverfahren nach einem Startvorgang des Wechselrichters 1, sodass stabile Werte am Eingang des Wechselrichters 1 zur Verfügung stehen.

In definierten Abständen kann auch ein Testlauf des Detektionsverfahrens durchgeführt werden. Dabei wird die Funktion des Detektionsverfahrens überprüft. Beispielsweise erfolgt dies direkt vom Wechselrichter 1 oder durch ein externes Gerät, wobei dies in einem Ruhezustand der Photovoltaikanlage erfolgt. Der Testlauf erfolgt beispielsweise derart, dass am Eingang des Wechselrichters 1 sich unterschiedlich schnell ändernde Spannungs- und/oder Stromverläufe angelegt werden, welche beispielsweise von einem Impulsgenerator, Signalgenerator oder dergleichen erzeugt werden. Ebenso können diese Spannungs- und/oder Stromverläufe auch durch bestimmte Werte simuliert werden. Diese Werte werden entsprechend dem Detektionsverfahren anstelle der kontinuierlich gemessenen Werte von Strom I_{DC} und Spannung U_{DC} verwendet. Die Amplituden dieser Verläufe sind an die Ausgangsleistung des Wechselrichters 1 entsprechend angepasst. Die Verläufe werden mit einer entsprechenden Frequenz verändert, sodass sowohl langsame als auch schnelle Änderungen simuliert werden können. Demnach darf bei geringen Frequenzen der Verläufe kein Lichtbogen detektiert werden - da dies einer Änderung der Einstrahlungsstärke entspricht, wobei bei höheren Frequenzen ein Lichtbogen detektiert werden sollte. Durch geeignete Wahl der Amplitude kann auch überprüft werden, ob das Detektionsverfahren zwischen Serienlichtbögen und Parallellichtbögen unterscheiden kann.

## Patentansprüche

1. Verfahren zur Detektion von Lichtbögen in einem Gleichstrompfad einer Photovoltaikanlage, wobei Werte eines Stroms (I_{DC}) des Gleichstrompfads während eines sich wiederholenden Zeitfensters (7) erfasst und ein Mittelwert (8) des Stroms (I_{DC}) gebildet wird, während der Zeitfenster (7) Werte einer Spannung (U_{DC}) des Gleichstrompfads erfasst und ein Mittelwert (8') der Spannung (U_{DC}) gebildet wird, aus den jeweiligen Mittelwerten (8, 8') des Stroms (I_{DC}) und der Spannung (U_{DC}) Differenzmittelwerte und Langzeitmittelwerte (11, 11') des Stroms (I_{DC}) und der Spannung (U_{DC}) berechnet werden, aus den aktuellen Differenzmittelwerten des Stroms (I_{DC}) und der Spannung (U_{DC}) Langzeitdifferenzmittelwerte des Stroms (I_{DC}) und der Spannung (U_{DC}) berechnet werden, und dass basierend auf den Mittelwerten (8, 8'), Differenzmittelwerten, Langzeitmittelwerten (11, 11') und Langzeitdifferenzmittelwerten für den Strom (I_{DC}) und die Spannung (U_{DC}) über ein Berechnungsverfahren zumindest ein Detektionssignal (9) und zumindest eine Detektionsschwelle (10) kontinuierlich berechnet wird, indem aus dem Langzeitdifferenzmittelwert und dem Differenzmittelwert der Spannung (U_{DC}) ein Wert gebildet wird und mit einem aus dem Langzeitdifferenzmittelwert und dem Differenzmittelwert des Stroms (I_{DC}) gebildeten Wert zur Bildung des Detektionssignals (9) multipliziert wird.

2. Verfahren nach Anspruch 1, **dadurch gekennzeichnet, dass** die Langzeitmittelwerte (11, 11') des Stroms (I_{DC}) und der Spannung (U_{DC}) durch digitale Tiefpassfilterung aus den jeweiligen Mittelwerten (8, 8') des Stroms (I_{DC}) und der Spannung (U_{DC}) berechnet werden.

3. Verfahren nach Anspruch 1 oder 2, **dadurch gekennzeichnet, dass** die Langzeitdifferenzmittelwerte des Stroms (I_{DC}) und der Spannung (U_{DC}) durch digitale Tiefpassfilterung aus den jeweiligen Differenzmittelwerten des Stroms (I_{DC}) und der Spannung (U_{DC}) berechnet werden.

4. Verfahren nach einem der Ansprüche 1 bis 3, **dadurch gekennzeichnet, dass** nach jedem Zeitfenster (7) das Detektionssignal (9) und die Detektionsschwelle (10) anhand des Differenzmittelwerts, des Langzeitmittelwerts (11, 11') und des Langzeitdifferenzmittelwerts jeweils des Stroms (I_{DC}) und der Spannung (U_{DC}) berechnet wird.

5. Verfahren nach einem der Ansprüche 1 bis 4, **dadurch gekennzeichnet, dass** die Werte des Detektionssignals (9) mit einem Korrekturfaktor größer 1 multipliziert werden.

6. Verfahren nach einem der Ansprüche 1 bis 5, **dadurch gekennzeichnet, dass** die Langzeitmittelwerte (11, 11') des Stroms (I_{DC}) und der Spannung (U_{DC}) zur Bildung der Detektionsschwelle (10) multipliziert werden.

7. Verfahren nach Anspruch 6, **dadurch gekennzeichnet, dass** die Detektionsschwelle (10) für die Erkennung eines Serienlichtbogens mit einem Korrekturfaktor kleiner 1 multipliziert wird.

8. Verfahren nach Anspruch 6, **dadurch gekennzeichnet, dass** die Detektionsschwelle (10) für die Erkennung eines Parallellichtbogens mit einem Korrekturfaktor kleiner 1 multipliziert wird.

9. Verfahren nach einem der Ansprüche 1 bis 8, **dadurch gekennzeichnet, dass** ein Lichtbogen detektiert wird, wenn die Detektionsschwelle (10) vom Detektionssignals (9) überschritten wird, und zwischen einem Serienlichtbogen und einem Parallellichtbogen unterschieden wird.

10. Verfahren nach einem der Ansprüche 1 bis 9, **dadurch gekennzeichnet, dass** nach Detektion eines Lichtbogens dieser gelöscht wird.

11. Verfahren nach Anspruch 10, **dadurch gekennzeichnet, dass** zur Löschung des Parallellichtbogens der Gleichstrompfad mit einem Schalter kurzgeschlossen wird und zur Löschung des Serienlichtbogens der Stromfluss im Gleichstrompfad unterbrochen wird.

12. Verfahren nach einem der Ansprüche 1 bis 11, **dadurch gekennzeichnet, dass** die Funktion des Detektionsverfahrens mit einem Testlauf überprüft wird.

13. Verfahren nach einem der Ansprüche 1 bis 12, **dadurch gekennzeichnet, dass** das Detektionsverfahren nach einem Startvorgang der Photovoltaikanlage aktiviert wird.

14. Photovoltaikanlage mit Komponenten zum Einspeisen in ein Wechselspannungsnetz (3), mit einem DC-DC-Wandler (4) und einem DC-AC-Wandler (5) zur Umwandlung der von zumindest einer Solarzelle (2) erzeugten Gleichspannung (U_{DC}) mit zugehörigem Gleichstrom (I_{DC}) in eine Wechselspannung (U_{AC}) zur Einspeisung in das Wechselspannungsnetz (3), und einer Steuereinrichtung (6), **dadurch gekennzeichnet, dass** eine Messeinrichtung zur Messung der Gleichspannung (U_{DC}) und des Gleichstromes (I_{DC}) vorgesehen ist, und dass die Steuereinrichtung (6) zur Durchführung des Verfahrens zur Detektion von Lichtbögen in einem Gleichstrompfad der Photovoltaikanlage gemäß den Ansprüchen 1 bis 13 ausgebildet ist.

## Claims

1. Method for detecting arcs in a direct-current path of a photovoltaic system, wherein values of a current (I_{DC}) of the direct-current path are detected during a repeating time frame (7) and a mean value (8) of the current (I_{DC}) is generated, values of a voltage (U_{DC}) of the direct-current path are detected during the time frames (7) and a mean value (8') of the voltage (U_{DC}) is generated, difference mean values and long-term mean values (11, 11') of the current (I_{DC}) and the voltage (U_{DC}) are calculated from the respective mean values (8, 8') of the current (I_{DC}) and the voltage (U_{DC}), long-term difference mean values of the current (I_{DC}) and the voltage (U_{DC}) are calculated from the current difference mean values of the current (I_{DC}) and the voltage (U_{DC}), and wherein based on the mean values (8, 8'), difference mean values, long-term mean values (11, 11') and long-term difference mean values for the current (I_{DC}) and the voltage (U_{DC}), at least one detection signal (9) and at least one detection threshold (10) are continuously calculated by means of a calculation method, by a value being generated from the long-term difference mean value and the difference mean value of the voltage (U_{DC}) and being multiplied by a value generated from the long-term difference mean value and the difference mean value of the current (I_{DC}) in order to form the detection signal (9).

2. The method according to Claim 1, **characterized in that** the long-term mean values (11, 11') of the current (I_{DC}) and the voltage (U_{DC}) are calculated from the respective mean values (8, 8') of the current (I_{DC}) and the voltage (U_{DC}) by digital low-pass filtering.

3. The method according to Claim 1 or 2, **characterized in that** the long-term difference mean values of the current (I_{DC}) and the voltage (U_{DC}) are calculated from the respective difference mean values of the current (I_{DC}) and the voltage (U_{DC}) by digital low-pass filtering.

4. The method according to any one of Claims 1 to 3, **characterized in that** after each time frame (7), the detection signal (9) and the detection threshold (10) are calculated by means of the difference mean value, the long-term mean value (11, 11') and the long-term difference mean value of each of the current (I_{DC}) and the voltage (U_{DC}).

5. The method according to any one of Claims 1 to 4, **characterized in that** the values of the detection signal (9) are multiplied by a correction factor greater than 1.

6. The method according to one of Claims 1 to 5, **characterized in that** the long-term mean values (11, 11') of the current (I_{DC}) and the voltage (U_{DC}) are multiplied to generate the detection threshold (10).

7. The method according to Claim 6, **characterized in that** the detection threshold (10) is multiplied by a correction factor less than 1 for detecting a series arc.

8. The method according to Claim 6, **characterized in that** the detection threshold (10) is multiplied by a correction factor less than 1 for detecting a parallel arc.

9. The method according to any one of Claims 1 to 8, **characterized in that** an arc is detected when the detection threshold (10) is exceeded by the detection signal (9), and a distinction is made between a series arc and a parallel arc.

10. The method according to any one of Claims 1 to 9, **characterized in that** after detection of an arc, said arc is extinguished.

11. The method according to Claim 10, **characterized in that** to extinguish the parallel arc the direct-current path is short-circuited with a switch, and to extinguish the series arc the current flow in the direct-current path is interrupted.

12. The method according to any one of Claims 1 to 11, **characterized in that** the functioning of the detection method is checked with a test run.

13. The method according to any one of Claims 1 to 12, **characterized in that** the detection method is activated after a starting process of the photovoltaic system.

14. Photovoltaic system having components for feeding power into an AC voltage grid (3), having a DC-DC-converter (4) and a DC-AC-converter (5) for converting the DC voltage (U_{DC}) with associated direct current (I_{DC}) generated by at least one solar cell (2) into an AC voltage (U_{AC}) for feeding into the AC voltage grid (3), and having a control device (6), **characterized in that** a measurement device for measuring the DC voltage (U_{DC}) and the direct current (I_{DC}) is provided, and that the control device (6) is designed for carrying out the method for detecting arcs in a direct-current path of the photovoltaic system according to Claims 1 to 13.

## Revendications

1. Procédé de détection d'arcs électriques dans un circuit de courant continu d'une installation photovoltaïque, les valeurs d'un courant (I_{DC}) du circuit de courant continu étant déterminées au cours d'un intervalle de temps (7) qui se répète et une valeur moyenne (8) du courant (I_{DC}) étant obtenue, des valeurs d'une tension (U_{DC}) du circuit de courant continu sont déterminées au cours de l'intervalle de temps (7) et une valeur moyenne (8') de la tension (U_{DC}) est obtenue, des valeurs moyennes différentielles et valeurs moyennes de longue durée (11, 11') du courant (I_{DC}) et de la tension (U_{DC}) sont calculées à partir des valeurs moyennes respectives (8, 8') du courant (I_{DC}) et de la tension (U_{DC}), des valeurs moyennes différentielles de longue durée du courant (I_{DC}) et de la tension (U_{DC}) sont calculées à partir des valeurs moyennes différentielles effectives du courant (I_{DC}) et de la tension (U_{DC}), et sur la base des valeurs moyennes (8, 8'), des valeurs moyennes différentielles, des valeurs moyennes de longue durée (11, 11') et des valeurs moyennes différentielles de longue durée pour le courant (I_{DC}) et la tension (U_{DC}), au moins un signal de détection (9) et au moins un seuil de détection (10) sont calculés de manière continue via un procédé de calcul, une valeur étant obtenue à partir de la valeur moyenne différentielle de longue durée et de la valeur moyenne différentielle de la tension (U_{DC}) et multipliée par une valeur obtenue à partir de la valeur moyenne différentielle de longue durée et de la valeur moyenne différentielle du courant (I_{DC}) afin de former le signal de détection (9).

2. Procédé selon la revendication 1, **caractérisé en ce que** les valeurs moyennes de longue durée (11, 11') du courant (I_{DC}) et de la tension (U_{DC}) sont calculées via un filtrage passe-bas numérique à partir des valeurs moyennes respectives (8, 8') du courant (I_{DC}) et de la tension (U_{DC}).

3. Procédé selon la revendication 1 ou 2, **caractérisé en ce que** les valeurs moyennes différentielles de longue durée du courant (I_{DC}) et de la tension (U_{DC}) sont calculées via un filtrage passe-bas numérique à partir des valeurs moyennes différentielles respectives du courant (I_{DC}) et de la tension (U_{DC}).

4. Procédé selon l'une quelconque des revendications 1 à 3, **caractérisé en ce qu'**après chaque intervalle de temps (7), le signal de détection (9) et le seuil de détection (10) sont calculés à l'aide de la valeur moyenne différentielle, de la valeur moyenne de longue durée (11, 11') et de la valeur moyenne différentielle de longue durée, respectivement, du courant (I_{DC}) et de la tension (U_{DC}).

5. Procédé selon l'une quelconque des revendications 1 à 4, **caractérisé en ce que** les valeurs du signal de détection (9) sont multipliées par un facteur de correction supérieur à 1.

6. Procédé selon l'une quelconque des revendications 1 à 5, **caractérisé en ce que** les valeurs moyennes de longue durée (11, 11') du courant (I_{DC}) et de la tension (U_{DC}) sont multipliées afin d'obtenir le seuil de détection (10).

7. Procédé selon la revendication 6, **caractérisé en ce que** le seuil de détection (10) pour l'identification d'un arc électrique en série est multiplié par un facteur de correction inférieur à 1.

8. Procédé selon la revendication 6, **caractérisé en ce que** le seuil de détection (10) pour l'identification d'un arc électrique parallèle est multiplié par un facteur de correction inférieur à 1.

9. Procédé selon l'une quelconque des revendications 1 à 8, **caractérisé en ce qu'**un arc électrique est détecté lorsque le seuil de détection (10) est dépassé par le signal de détection (9) et une distinction est opérée entre un arc électrique en série et un arc électrique parallèle.

10. Procédé selon l'une quelconque des revendications 1 à 9, **caractérisé en ce qu'**après la détection d'un arc électrique, celui-ci est éteint.

11. Procédé selon la revendication 10, **caractérisé en ce que** pour éteindre l'arc électrique parallèle, le circuit de courant continu est mis en court-circuit avec un commutateur, et pour éteindre l'arc électrique en série, le courant électrique dans le circuit de courant continu est coupé.

12. Procédé selon l'une quelconque des revendications 1 à 11, **caractérisé en ce que** le fonctionnement du procédé de détection est vérifié avec un cycle d'essai.

13. Procédé selon l'une quelconque des revendications 1 à 12, **caractérisé en ce que** le procédé de détection est activé après un processus de démarrage de l'installation photovoltaïque.

14. Installation photovoltaïque comprenant des composants d'injection dans un réseau à tension alternative (3), comprenant un convertisseur CC-CC (4) et un convertisseur CC-CA (5) destinés à convertir la tension continue (U_{DC}) produite par au moins une cellule solaire (2), avec le courant continu (I_{DC}) correspondant, dans une tension alternative (U_{AC}) pour l'injection dans le réseau à tension alternative (3), et un dispositif de commande (6), **caractérisée en ce qu'**un dispositif de mesure est prévu pour mesurer la tension continue (U_{DC}) et le courant continu (I_{DC}) et **en ce que** le dispositif de commande (6) est conçu pour mettre en oeuvre le procédé de détection d'arcs électriques dans un circuit de courant continu de l'installation photovoltaïque selon les revendications 1 à 13.
